# EUROPEAN PATENT APPLICATION

(11) **EP 2 923 893 A1**
(43) Date of publication of application: **30.09.2015**
(21) Application number: 13856698.9
(22) Date of filing: 25.11.2013
(51) Int. Cl.: B60R 16/02

(54) **ELECTRONIC CONTROL DEVICE**

(30) Priority: 26.11.2012 JP 2012257286
(71) Applicant: Yazaki Corporation, Minato-ku Tokyo 108-8333 (JP)
(72) Inventor: SUZUKI, Masashi, Makinohara-shi Shizuoka 421-0407 (JP)
(74) Representative: Grünecker Patent- und Rechtsanwälte PartG mbB
(86) International application number: PCT/JP2013/081602
(87) International publication number: WO 2014/081028

(57) **Abstract**

Provided is an electronic control device capable of preventing all of semiconductor relays from being forcibly controlled to be opened by a self-protection shutoff function. An electronic control device (E) controls semiconductor relays (D1-Dn) provided in a load control unit (U), which correspond to loads (L1-Ln) mounted in an automobile. The electronic control device includes a temperature measuring means (P1) which measures the ambient temperature of the semiconductor relays (D1-Dn). The electronic control device also includes an operation restricting means (P2) which, when the temperature measured by the temperature measuring means (P1) is higher than or equal to an operation restriction temperature threshold set within an ambient temperature range in which the self-protection shutoff function is not performed in the semiconductor relays (D1-Dn), performs control for opening semiconductor relays (Dj) that correspond to some loads (Lj) among the loads (L1-Ln).

## Description

### TECHNICAL FIELD

The present invention relates to an electronic control device that controls a plurality of semiconductor relays that is disposed in a load control unit and correspond to a plurality of loads mounted on an automobile.

### BACKGROUND ART

Conventionally, loads mounted on an automobile, such as head lamps, a radiator fan, position lamps, and fog lamps, are connected to a power supply via mechanical relays having contacts that are opened and closed electromagnetically. As the mechanical relays are controlled to open and close, electricity feeding is carried out and stopped, and operations of the loads are controlled. In recent years, there are demands for a PWM (pulse width modulation) control on the loads and for size reduction of a load control unit. To meet such demands, semiconductor relays that use semiconductor switching elements are often employed instead of the mechanical relays. For example, Patent Literature 1 discloses one example of a power feed control device that uses semiconductor switching elements as semiconductor relays.

Since a plurality of loads is mounted on an automobile, a plurality of semiconductor relays is disposed corresponding to the loads. In order to improve the assembling performance or for other reasons, a plurality of semiconductor relays is mounted at one place on a substrate, depending upon type of the load(s) or the like, and the substrate is packaged in a casing or the like to configure a load control unit having a plurality of semiconductor relays.

### LIST OF PRIOR ART REFERENCES

### PATENT LITERATURES

PATENT LITERATURE 1: Japanese Patent Application Laid-Open Publication No. 2000-236247

### SUMMARY OF THE INVENTION

### PROBLEMTS TO BE SOLVED BY THE INVENTION

The upper limit of a temperature range for normal operation of the above-described semiconductor relay is set to a low value, as compared to the mechanical relay. The semiconductor relay has a self-protection shutoff function that forcibly opens (breaks) the contact to interrupt the feeding of the electric current (turn-off control) when the temperature of the semiconductor relay exceeds the upper limit. If the load control unit receives thermal interference from outside because of a certain reason, or an overcurrent flows over a prescribed value in some of the semiconductor relays, then the inside temperature of the load control unit rises, and the temperature of the semiconductor relays may exceed the upper limit such that the self-protection shutoff function may be triggered in all the semiconductor relays. This is a problem because the electric current to be supplied to the head lamps, the radiator fan, and other components and parts, which are of high importance to the traveling of the automobile, is shut off and their functions are stopped.

An object of the present invention is to overcome the above-mentioned problems. Specifically, an object of the present invention is to provide an electronic control device that prevents all the semiconductor relays from being forced to open by means of the self-protection shutoff function of the semiconductor relays.

### SOLUTION TO THE PROBLEMS

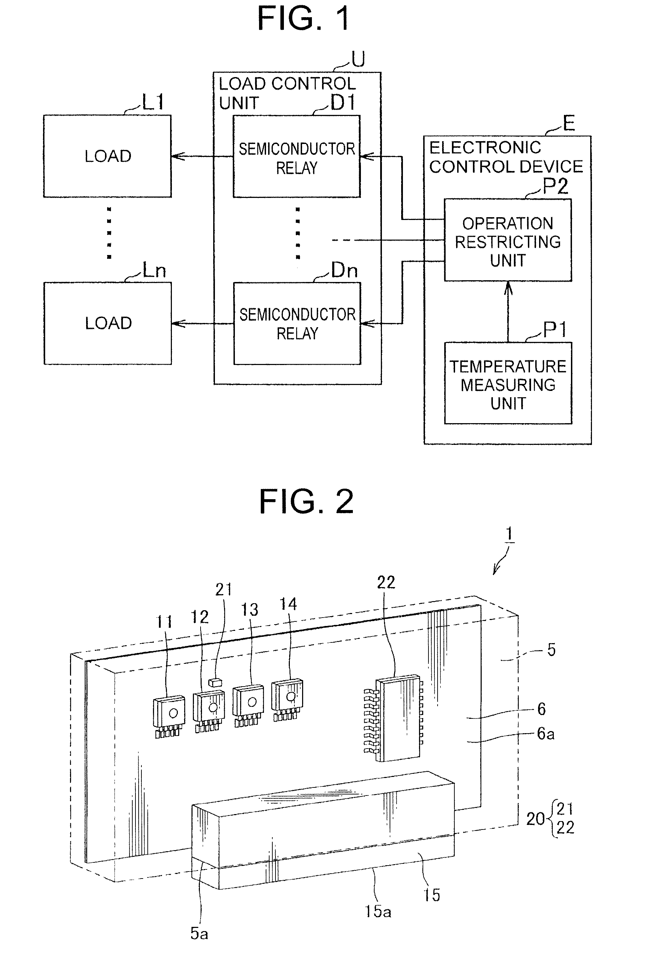

In order to achieve the object, as shown in a fundamental configuration view of Fig. 1, one aspect of the invention is directed to an electronic control device E configured to control a plurality of semiconductor relays D1-Dn that is disposed in a load control unit U and corresponds to a plurality of loads L1-Ln (n is a natural number equal to or greater two) mounted on an automobile. The electronic control device E includes a temperature measuring unit P1 configured to measure a surrounding temperature of the semiconductor relays D1-Dn, and an operation restricting unit P2 configured to open the semiconductor relay(s) Dj (j is one or a natural number greater than one between one and n) which correspond(s) to one or more loads Lj among the entire loads L1-Ln when the temperature measured by the temperature measuring unit P1 is equal to or higher than an operation restricting temperature threshold. The operation restricting temperature threshold is set within a predetermined ambient temperature range in which a self-protection shutoff function is not triggered in each of the semiconductor relays D1-Dn.

Another aspect of the invention is directed to the invention defined by claim 1, with said one or more loads Lj being the load(s) which is (are) of less importance among the entire loads L1-Ln.

### ADVANTAGES OF THE INVENTION

According to the one aspect of the invention, the ambient temperature of the semiconductor relays is measured. When the measured temperature is equal to or higher than the operation restricting temperature threshold, those semiconductor relays which correspond to some of the loads are controlled to open. The operation restricting temperature threshold is set within the predetermined ambient temperature range in which the self-protection shutoff function is not triggered in each of the semiconductor relays. Thus, the number of those semiconductor relays which feed the electric current to the loads decreases, and it is possible to restrict the elevation of the ambient temperature by the semiconductor relays. This prevents all the semiconductors relays from being forcibly opened due to the self-protection shutoff function.

According to the other aspect of the invention, some loads Lj are less important loads among the entire loads L1-Ln. Thus, it is possible to perform the control such that those semiconductor relays which correspond to the less important loads are forced to open to shut off the electric current to be fed to the less important loads. Accordingly, the important loads can continue to operate, and it is possible to prevent all the semiconductor relays from being forcibly opened due to the self-protection shutoff function.

### BRIEF DESCRIPTION OF THE DRAWINGS

Fig. 1 illustrates a fundamental structure of an electronic control device according to one embodiment of the present invention.
Fig. 2 is a transparent and perspective view of a load control unit that has the electronic control device according to the embodiment of the present invention therein.
Fig. 3 schematically illustrates connections between the electric control device and a plurality of semiconductor relays, which are built in the load control unit shown in Fig. 2, and loads mounted on an automobile.
Fig. 4 is a flowchart of exemplary processing (processing for operation restriction) according to the present invention, which is executed by a CPU of a microcomputer in the load control unit shown in Fig. 3.
Fig. 5 illustrates a flowchart of exemplary processing (control and processing upon manipulation of operation switches and the like), which is executed by the CPU of the microcomputer in the load control unit shown in Fig. 3.
Fig. 6 is a graph that schematically shows the temperature change in the load control unit shown in Fig. 2.

### DISCRIPTION OF EMBODIMENTS

Now, a load control unit having an electronic control device according to one embodiment of the present invention will be described with reference to Figs. 2-6. The load control unit is configured to perform an on/off control on head lamps, a radiator fan, position lamps and fog lamps. In this embodiment, the head lamps, the radiator fan and the position lamps are loads which are indispensable to the travelling of an automobile, and which are important loads for the travelling of the automobile. The fog lamps are auxiliary loads, and therefore the fog lamps are less important loads than the head lamps, the radiator fan and the position lamps.

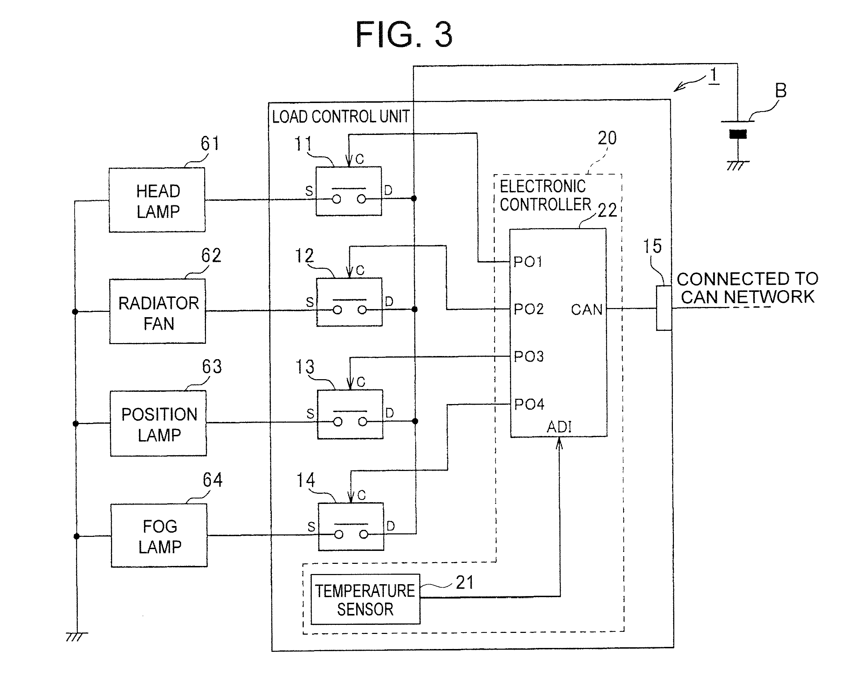

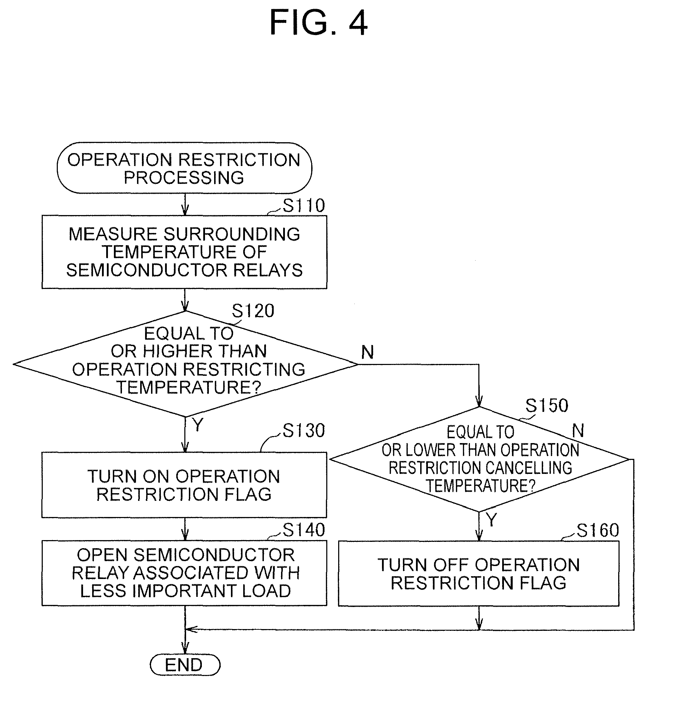

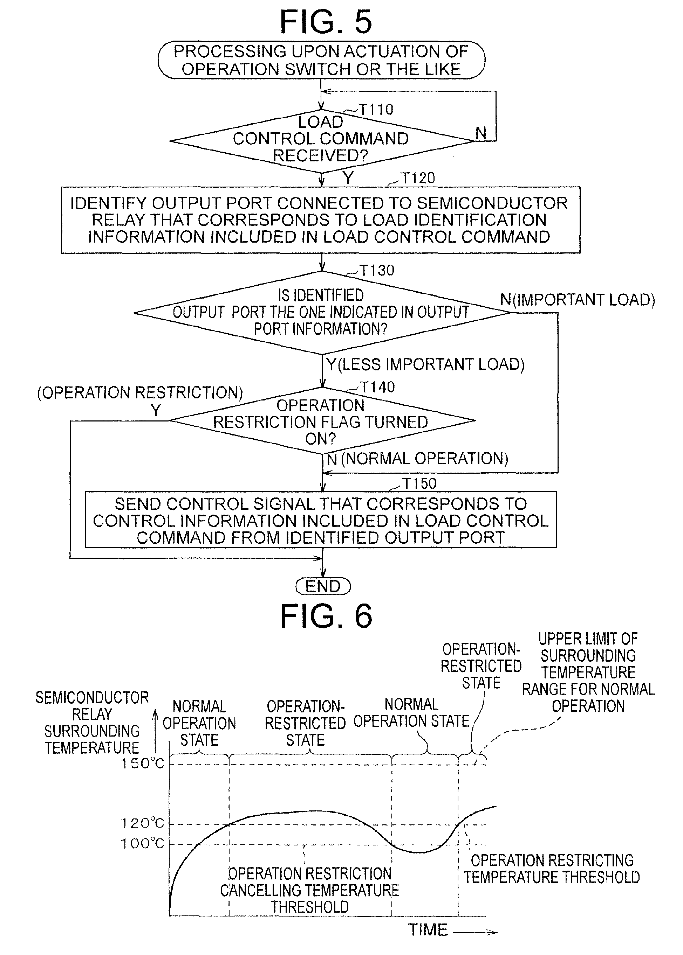

Fig. 2 shows a transparent and perspective view of a load control unit that has the electronic control device of this embodiment therein. Fig. 3 schematically shows connections between the electric control device and a plurality of semiconductor relays, which are built in the load control unit shown in Fig. 2, and loads mounted on the automobile. Fig. 4 is a flowchart of exemplary processing (processing for operation restriction) according to this embodiment, which is executed by a CPU of a microcomputer in the load control unit shown in Fig. 3. Fig. 5 illustrates a flowchart of exemplary processing (control and processing upon manipulation of operation switches and the like), which is executed by the CPU of the microcomputer in the load control unit shown in Fig. 3. Fig. 6 is a graph that schematically shows the temperature change inside the load control unit shown in Fig. 2.

As shown in Fig. 2, the load control unit (designated at the reference numeral 1 in the drawing) includes a casing 5, a printed circuit board 6, a plurality of semiconductor relays 11-14, a connector 15, and an electronic controller 20 having a temperature sensor 21 and a microcomputer 22. In Fig. 2, the casing 5 of the load control unit 1 is transparent.

The casing 5 is made from, for example, synthetic resin and is box-shaped in a form of rectangle viewed from the top. One face (downwardly directed face in the drawing) of the casing 5 has an opening 5a to allow the connector 15 mentioned later to project outward. A printed circuit board 6 having a rectangular plate shape is housed in the casing 5.

The semiconductor relays 11-14 include, for example, semiconductor switching elements that have N channel power MOSFETs, which are also referred to as "thermal shutdown FETs" or the like. The N channel power MOSFET possesses a self-protection shutoff function that is triggered when subjected to an over-temperature. Of course, the semiconductor relays 11-14 are not limited to the power MOSFETs. For example, the semiconductor relays 11-14 may include other type of semiconductor switching elements such as transistors or FETs. These semiconductor relays 11-14 are linearly arranged next to each other on one surface 6a of the printed circuit board 6. As shown in Fig. 3, drain terminals D - source terminals S of the semiconductor relays 11-14 are connected in series between a power supply B and the associated loads 61-64. Specifically, the drain and source terminals D-S of the semiconductor relay 11 are connected in series between the power supply B and the head lamps 61, the drain and source terminals D-S of the semiconductor relay 12 are connected in series between the power supply B and the radiator fan 62, the drain and source terminals D-S of the semiconductor relay 13 are connected in series between the power supply B and the position lamps 63, and the drain and source terminals D-S of the semiconductor relay 14 are connected in series between the power supply B and the fog lamps 64. Gate terminals G of the semiconductor relays 11-14 are connected to the microcomputer 22 of the electronic controller 20 to be mentioned later such that opening and closing of the gate terminals G is controlled by control signals sent from the microcomputer 22.

The connector 15 is coupled to a not-shown wiring harness. The wiring harness extends into the automobile and connects a plurality of electronic control devices to each other. Thus, the connector 15 and these electronic control devices establish in combination a CAN network. The connector 15 is attached along one edge of the surface 6a of the printed circuit board 6 such that an engaging portion 15a of the connector 15 protrudes to the outside from the opening 5a of the casing 5.

The electronic controller 20 has the temperature sensor 21 and the microcomputer 22 (hereinafter, it may be referred to as "µCOM 22").

The temperature sensor 21 includes, for example, a thermistor, and generates a signal (analog signal) that represents the surrounding temperature. The temperature sensor 21 is attached to the surface 6a of the printed circuit board 6 and located in the vicinity of the semiconductor relays 11-14 to the extent that the surrounding temperature of the temperature sensor 21 becomes substantially equal to the surrounding temperature of the semiconductor relays 11-14. The temperature sensor 21 is connected to the microcomputer 22, and the microcomputer 22 measures the surrounding temperature of the temperature sensor 21, i.e., the surrounding temperature of the semiconductor relays 11-14, based on the signal sent from the temperature sensor 21.

The microcomputer 22 has the CPU, a ROM, a RAM and other elements therein, and carries out the control over the entire load control unit 1. The ROM stores control programs in advance to allow the CPU to function as various units such as the temperature measuring unit and the operation restricting unit. The CPU functions as the various units when the CPU executes the control programs. The ROM of the microcomputer 22 stores, for example, (1) a temperature conversion table that shows relationship between a numerical value that is indicated by the signal generated from the temperature sensor 21 and the surrounding temperature of the semiconductor relays 11-14, (2) an operation restricting temperature threshold (e.g., 120 degrees C) that is set in a normal operation surrounding temperature range (e.g., 0-150 degrees C) in which the self-protection shutoff function of the semiconductor relays 11-14 is not triggered, and an operation restriction cancelling temperature threshold (e.g., 100 degrees C) that is lower than the operation restricting temperature threshold, and (3) parameters such as information about output ports mentioned later to which those semiconductor relay(s), which are associated with less important loads for the travelling of the automobile, are connected (e.g., information about the output port PO4 to which the semiconductor relay 14 associated with the fog lamps 64 is connected).

The microcomputer 22 also has an external interface part that includes the output ports PO1-PO4, an analog-digital conversion input port ADI, and a communication port CAN for the CAN communication. The output ports PO1-PO4 are connected to the semiconductor relays 11-14, respectively. The opening and closing of the semiconductor relays 11-14 is controlled by control signals issued from the associated output ports PO1-PO4. The temperature sensor 21 is connected to the analog-digital conversion input port ADI. As the analog signal is entered to the analog-digital conversion input port from the temperature sensor 21, the analog signal is quantized such that the numerical value that corresponds to the analog signal, i.e., the numerical value that indicates the temperature, is entered to the CPU. The connector 15 is connected to the communication port CAN to perform the communication to other electronic control devices through the wiring harness (not shown) connected to the connector 15.

When a person in the automobile actuates a switch and enters a certain switching command to a particular load through the switch, such as a command for turning on or off the head lamps, then the above-mentioned other electronic device detects the actuation of the switch, and sends information, which corresponds to the actuation of the switch, to the load control unit 1 through the CAN network. Thus, the electronic controller 20 of the load control unit 1 controls the load 61-64 based on the received information. Specifically, the electronic controller 20 controls the opening or closing of the semiconductor relays 11-14.

Now, exemplary processing (operation restriction processing) performed by the CPU of the microcomputer 22 according to this embodiment of the invention will be described with reference to the flowchart shown in Fig. 4.

The CPU of the microcomputer 22 periodically (e.g., every one minute) proceeds to Step S110 in order to carry out the operation restriction processing.

At Step S110, the surrounding temperature of the semiconductor relays 11-14 is measured. Specifically, the CPU acquires (namely, measures) the temperature that corresponds to the numeral value as the surrounding temperature of the semiconductor relays 11-14 by applying the numerical value represented by the signal received from the temperature sensor 21, to the temperature conversion table stored in the ROM. Then, the CPU proceeds to Step S120.

At Step S120, the CPU determines whether the surrounding temperature of the semiconductor relays 11-14 measured at Step S110 is equal to or greater than the operation restricting temperature threshold stored in the ROM. When the temperature is equal to or greater than the operation restricting temperature threshold, the CPU proceeds to Step S130 (Yes at Step S120). When the temperature is less than the operation restricting temperature threshold, the CPU proceeds to Step S150 (No at Step S120).

At Step S130, the CPU sets a flag of "operation restriction being performed" in the RAM. In other words, the CPU turns on the flag of "operation restriction being performed." This indicates that some semiconductor relays are in the operation-restricted state. Then, the CPU proceeds to Step S140.

At Step S140, the semiconductor relay associated with the less important load is controlled to be opened. Specifically, the CPU reads from the RAM the information stored in the ROM about the output port (output port PO4) connected to the semiconductor relay associated with that load which is less important for the travelling of the automobile. The CPU sends a signal from the output port PO4, which is indicated by the information, to open the semiconductor relay. This causes the semiconductor relay 14, which is connected to the output port PO4, to open, and stops the electric current to the fog lamps 64, which is connected to the semiconductor relay 14. Then, the CPU finishes the processing of this flowchart.

At Step S150, the CPU determines whether the surrounding temperature of the semiconductor relays 11-14 measured at Step S110 is equal to or lower than the operation restriction cancelling temperature threshold stored in the ROM. When the surrounding temperature of the semiconductor relays 11-14 is equal to or lower than the operation restriction cancelling temperature threshold (Yes at Step S150), the CPU proceeds to Step S160. When the surrounding temperature of the semiconductor relays 11-14 is greater than the operation restriction cancelling temperature threshold (No at Step S150), the CPU finishes the processing of this flowchart.

At Step S160, the CPU lowers the flag of "operation restriction being performed" in the RAM. In other words, the CPU turns off the flag of "operation restriction being performed." This indicates that none of the semiconductor relays are not in the operation-restricted state (i.e., the semiconductor relay 14 is in the normal operation state). Then, the CPU finishes the processing of this flowchart.

The combination of Step S110 and the temperature sensor 21 corresponds to the temperature measuring unit in the claims. Step S140 corresponds to the operation restricting unit in the claims.

Referring now to Figs. 4 and 5, an exemplary operation of the electronic controller 20 in the load control unit 1 will be described.

### Control Process by Actuation Of Operation Switches And The Like

When a person in the automobile actuates the operation switch for the load, the other electronic control device detects the actuation of the operation switch and sends information, which represents the actuation of the operation switch, (hereinafter referred to as "load control command") to the load control unit 1 (more specifically, to the electronic controller 20). The load control command includes load identification information that represents the load to be controlled, and control information that represents the control to be applied to the load (turning on or off).

Upon receiving the load control command (Yes at T110 in Fig. 5), the electronic controller 20 of the load control unit 1 identifies the output port which is connected to the semiconductor relay associated with the load indicated in the load identification information included in the load control command (T120). Subsequently, the electronic controller 20 determines whether the identified output port is the output port indicated in the information of the output port connected to the semiconductor relay associated with the less important load for the travelling of the automobile (T130). This information of the output port is stored in the ROM and referred to as "output port information" hereinafter.

Thus, when the identified output port is not the output port indicated in the output port information, i.e., when the identified output port is the output port that is connected to the semiconductor relay associated with an important load for the travelling of the automobile (No at T130), a control signal corresponding to the control information and included in the load control command is output from the identified output port (T150).

When the identified output port is the output port indicated in the output port information, i.e., when the identified output port is the output port that is connected to the semiconductor relay associated with a less important load for the travelling of the automobile (Yes at T130), the flag of "operation restriction being performed" in the RAM the electronic controller is determined, and if the flag is in the off state (No at T140), a control signal corresponding to the control information included in the load control command is output from the identified output port (T150) as the normal operation state, otherwise if the flag is in the on state (Yes at T140), the process ends without outputting a control signal from the identified output port as the operation-restricted state (that is, the load control command is discarded.

For example, when a person in the automobile actuates the operation switch for the head lamps 61 from the unlit position to the lighting position (operation for turning on the head lamps), the other electronic control device detects this actuation of the operation switch, and sends a load control command (i.e., the load identification information: the head lamps 61, the control information: ON) corresponding to the actuation of the operation switch to the load control unit 1. Upon receiving the load control command, the electronic controller 20 of the load control unit 1 identifies the output port PO1 that is connected to the semiconductor relay 11 associated with the load (head lamps 61) indicated in the load identification information included in the load control command. Subsequently, the electronic controller determines that the identified output port PO1 is not the output port PO4 indicated in the output port information, and outputs a control signal that corresponds to the control information (ON) included in the load control command, from the identified output port PO1. This causes the head lamps 61 to turn on for lighting. A similar operation is carried out when the operation switch for the head lamps 61 is actuated from the lighting position to the unlit position for turning off the head lamps 61. Also, a similar operation is carried out when the operation switch for the position lamps 63 is actuated for turning on and off the position lamps 63. In the case of the radiator fan 62, an operation similar to the operation for turning on and off the head lamps 61 is carried out except for the load control command being sent from the other electronic control device based on the temperature of the cooling water instead of the actuation of the operation switch.

When a person in the automobile actuates the operation switch for the fog lamps 64 from the unlit position to the lighting position (operation for turning on the fog lamps), the other electronic control device detects this actuation of the operation switch, and sends a load control command (i.e., the load identification information: the fog lamps 64, the control information: ON), which corresponds to the actuation of the operation switch, to the load control unit 1. Upon receiving the load control command, the electronic controller 20 of the load control unit 1 identifies the output port PO4 that is connected to the semiconductor relay 14 associated with the load (head lamps 64) indicated in the load identification information included in the load control command. Subsequently, the electronic controller determines that the identified output port PO4 is the output port PO4 indicated in the output port information, and checks the on/off state of the flag of "operation restriction being performed." If the flag is in the off state, the electronic controller generates a control signal that corresponds to the control information (ON) included in the load control command, from the identified output port PO4. If the flag is in the on state, the electronic controller terminates the processing without generating a control signal from the identified port PO4. Thus, the fog lamps 64 are turned on when the semiconductor relay is in the normal operation state whereas the turning on of the fog lamps 64 is restricted when the semiconductor relay is in the operation-restricted state. A similar operation (turning off the fog lamp) is carried out when the operation switch for the fog lamps 64 is actuated from the lighting position to the unlit position for turning off the fog lamps 64.

### Processing for Operation Restriction

The electronic controller 20 of the load control unit 1 periodically measures the surrounding temperature of the semiconductor relays 11-14 (Step S110 in Fig. 4), and determines whether the surrounding temperature of the semiconductor relays 11-14 is equal to or greater than the operation restricting temperature threshold. When the measured temperature is equal to or greater than the operation restricting temperature threshold (Yes at Step S120), the electronic controller 20 turns on the flag of "operation restriction being performed" in the RAM (Step S130), and opens the semiconductor relay 14 associated with the fog lamps 64, which is less important to the traveling of the automobile, regardless of the state of the operation switch (Step S140), so as to stop feeding the electric current to the fog lamps 64. When the flag of "operation restriction being performed" is set, i.e., when the semiconductor relays are in the operation-restricted state, the turning on of the fog lamps 64 is not accepted, as described above, so that the fog lamps 64 are maintained in the unlit state (Yes at T130 and Yes at T140 in Fig. 5). During the operation-restricted state, the actuations of the switches for turning on the head lamps 61, the radiator fan 62 and the position lamps 63 are accepted (No at T130 and T150 in Fig. 5). Also, when the surrounding temperature of the semiconductor relays 11-14 is lower than the operation restricting temperature threshold and greater than the operation restriction cancelling temperature threshold (No at Step S120 and No at Step S150), the operation-restricted state is maintained if the semiconductor relays are in the operation-restricted state, and the normal operation state is maintained if the semiconductor relays are in the normal operation state. When the surrounding temperature of the semiconductor relays 11-14 is equal to or lower than the operation restriction cancelling temperature threshold (No at Step S120 and Yes at Step S150), the electronic controller 20 turns off the flag of "operation restriction being performed." During the normal operation state, in which the flag of "operation restriction being performed" is turned off, the actuation of the switch for turning on the fog lamps 64 is accepted as described above, and the fog lamps are lit or unlit in response to the actuation entered to the operation switch (Yes at T130, No at T140 and T150 in Fig. 5). During the normal operation state, the actuations of the switches for turning on the head lamps 61, the radiator fan 62, the position lamps 63 and the like are accepted (No at T130 and T150 in Fig. 5).

Since by carrying out the above-described processing, the semiconductor relays 11-14 are brought into the operation-restricted condition when the surrounding temperature of the semiconductor relays 11-14 becomes equal to or higher than the operation restriction temperature threshold, one of the semiconductor relays 14 is brought into the open condition, and the heat generation from the semiconductor relay 14 is restricted, the surrounding temperature of the semiconductor relays 11-14 is thus restricted to rise. When the surrounding temperature of the semiconductor relays 11-14 becomes equal to or lower than the operation restriction cancelling temperature threshold, which is lower than the operation restricting temperature threshold, the operation restricting condition is cancelled, and therefore all the semiconductor relays 11-14 can operate normally. Fig. 6 is a graph that schematically shows an exemplary change in the surrounding temperature of the semiconductor relays 11-14 over time.

The electronic controller 20 of this embodiment is the electronic controller 20 configured to control a plurality of semiconductor relays 11-14 provided in the load control unit 1 and corresponding to a plurality of loads 61-64 provided in the automobile, the electronic controller 20 including the temperature measuring unit having the temperature sensor 21 for measuring the surrounding temperature of the semiconductor relays 11-14 and the CPU of the microcomputer 22, and the operation restricting unit having the CPU of the microcomputer 22 for opening the semiconductor relay 14 associated with the load 64 among the loads 61-64 when the temperature measured by the temperature measuring unit is equal to or higher than the operation restricting temperature threshold that is set in the predetermined surrounding temperature range in which the self-protection shutoff function for the semiconductor relays 11-14 is not triggered.

Also, the load 64 is the less important fog lamps 64 among a plurality of loads 61-64.

As understood from the foregoing, the surrounding temperature of the semiconductor relays 11-14 is measured, and the semiconductor relay 14 associated with the load 64 among the loads 61-64 is controlled to open when the measured temperature is equal to or higher than the operation restricting temperature threshold set in the predetermined surrounding temperature range in which the self-protection shutoff function is not triggered for the semiconductor relays 11-14 in the above-described embodiment. Therefore, it is possible to reduce the number of semiconductor relays that are used to feed the electric current to the loads, and suppress the elevation of the surrounding temperature of the semiconductor relays. This prevents all the semiconductor relays 11-14 from being forcibly opened due to the self-protection shutoff function.

Since the load 64 forced to open under the control of the electronic controller is the fog lamps 64 that are less important among a plurality of loads 61-64, and the semiconductor relay 14 associated with the less important fog lamps 64 is forced to open to shut off the electric current to the load, the important loads, It is possible for the head lamps 61, the radiator fan 62, and the position lamps 63 to continuously operate, and to prevent all the semiconductor relays 11-14 from being forced to open due to the self-protection shutoff function of the semiconductor relays.

Although the electronic controller 20 is provided in the load control unit 1 for controlling the semiconductor relays 11-14 in the above-described embodiment, the present invention is not limited to such configuration. For example, the function of the electronic controller 20 may be separated from the load control unit 1, and may be incorporated in a separate electronic control device.

It should be noted that the above-described embodiment is a mere typical example of the present invention, and the present invention is not limited to the embodiment. Various changes and modifications may be made to the described and illustrated embodiment without departing from the spirit and scope of the present invention.

### REFERENCE NUMERALS AND SYMBOLS

- 1:: Load control unit
- 11-14:: Semiconductor relay
- 20:: Electronic controller (electronic control device)
- 21:: Temperature sensor (temperature measuring unit)
- 22:: Microcomputer (temperature measuring unit, operation restricting unit)
- 61:: Head lamp (load)
- 62:: Radiator fan (load)
- 63:: Position lamp (load)
- 64:: Fog lamp (less important load)

## Claims

1. An electronic control device configured to control a plurality of semiconductor relays disposed in a load control unit and corresponding to a plurality of loads mounted on an automobile, the electronic control device comprising:
a temperature measuring unit configured to measure a surrounding temperature of the semiconductor relays; and
an operation restricting unit configured to open the semiconductor relay which corresponds to part of said plurality of loads when the temperature measured by the temperature measuring unit is equal to or higher than an operation restriction temperature threshold, the operation restriction temperature threshold being set within a predetermined surrounding temperature range in which a self-protection shutoff function is not triggered in each of the semiconductor relays.

2. The electric control device according to claim 1, wherein said part of said plurality of loads is a less important load among said plurality of loads.
